# DEMANDE DE BREVET EUROPEEN

(11) **EP 4 838 782 A2**
(43) Date de publication de la demande: **11.11.2026**
(21) Numéro de dépôt: 26200692.7
(22) Date de dépôt: 23.05.2023
(51) Int. Cl.: H03H 9/02

(54) **PROCEDE DE FABRICATION D'UN DISPOSITIF A ONDES ELASTIQUES DE SURFACE**

(30) Priorité: 02.06.2022 FR 2205311; 02.06.2022 FR 2205312; 02.06.2022 FR 2205313
(62) Numéro(s) de document de la (des) demande(s) initiale(s) en application de l'article 76 CBE: 23727382.6 / 4 533 661
(71) Demandeur: SOITEC, 38190 Bernin (FR)
(72) Inventeur: BALLANDRAS, Sylvain, 38190 BERNIN (FR); LAROCHE, Thierry, 38190 BERNIN (FR); BERNARD, Florent, 38190 BERNIN (FR); COURJON, Emilie, 38190 BERNIN (FR); N'DIAYE, Saly, 38190 BERNIN (FR); HUYET, Isabelle, 38190 BERNIN (FR)
(74) Mandataire: IP Trust

(57) **Abrégé**

L'invention concerne un Procédé de fabrication d'un dispositif à ondes élastiques configuré pour fonctionner à une fréquence inférieure à 1 GHz, et formé sur un substrat POI, la formation du substrat POI comprenant les étapes suivantes :
a) une étape d'implantation d'espèces dans un substrat LiTaO₃, ;
b) une étape de report de la couche utile sur une face avant d'un substrat support, ;
le procédé comprenant en outre la formation d'un empilement intermédiaire, intercalé entre la face avant et la couche utile, et qui comprend à partir de la face avant, une première couche, une deuxième couche et une troisième couche, la première couche et comprenant du dioxyde de silicium, la deuxième couche comprenant du nitrure de silicium, de l'alumine ou du nitrure d'aluminium, et la troisième couche comprenant du dioxyde de silicium ou du silicium amorphe.

## Description

### DOMAINE DE L'INVENTION

La présente invention se rapporte au domaine des dispositifs à ondes élastiques de surface. Plus particulièrement, la présente invention concerne un procédé de fabrication d'un dispositif à ondes élastiques de surface formé à partir d'un substrat POI qui comprend une couche de matériau piézoélectrique.

### ARRIERE PLAN TECHNOLOGIQUE DE L'INVENTION

Initialement fabriqués sur des substrats massifs de matériaux piézoélectriques mono-cristallins (ci-après « substrat massif »), les filtres à ondes élastiques de surface (« SAW filter » ou « Surface Acoustic Wave filter », selon la terminologie Anglo-Saxone) mettent désormais en œuvre des substrats piézoélectriques sur isolant (ci-après « POI »). Ces derniers comprennent notamment, d'une face avant vers une face arrière, une couche de matériau piézoélectrique, une couche de matériau diélectrique et un substrat support.

Ces substrats POI, contrairement aux substrats massifs, permettent de répondre à certaines exigences en termes de sensibilité à la température des modes élastiques de surface guidés dans la couche de matériau piézoélectrique.

Notamment, le substrat support joue le rôle de raidisseur et permet de limiter la dilatation thermique ainsi que d'influer sur le comportement thermoélastique de la couche de matériau piézoélectrique.

Ainsi, de manière générale, un mode élastique de surface se propageant sur un substrat POI, à partir duquel est formé un dispositif à ondes élastiques de surface, présente un coefficient de température de la fréquence (CTF ou « TCF » pour « Temperature coefficient of Frequency » selon la terminologie Anglo-Saxonne) relativement faible, et notamment inférieur à 10 ppm.K⁻¹, dans une gamme de fréquences qui s'étend de 1,4 GHz à 2,4 GHz.

La fabrication des substrats POI peut mettre en œuvre un procédé dit « SmartCut^{™} » bien connu du domaine de la micro-électronique, notamment pour la fabrication des substrats de silicium sur isolant.

A cet égard, le document [1] cité à la fin de la description propose de transférer une couche de matériau piézoélectrique, et plus particulièrement de LiNbO₃ (ci-après « LNO »), sur un substrat de silicium selon le procédé SmartCut^{™}.

Le document [2] cité à la fin de la description divulgue également la mise en œuvre d'un substrat POI exploitant une couche de LiTaO₃ pour la fabrication d'un filtre à ondes élastiques de surface. Le filtre à ondes élastiques de surface décrit dans ce document comprend un film de tantalate lithium sur une couche miroir formée d'une alternance de couches à impédance acoustique faible et des couches à impédance acoustique élevée sur un substrat de silicium.

Il a également été considéré d'intercaler une couche dite de piégeage, par exemple faite de silicium polycristallin, entre le substrat support et la couche de matériau diélectrique, et destinée à limiter le libre parcours moyen des charges aux interfaces de l'empilement ainsi que les diaphonies susceptibles d'intervenir au sein d'un filtre formé à partir du substrat POI considéré.

Les avantages du procédé SmartCut^{™} pour la formation d'un substrat POI sont bien connus. Notamment, le procédé SmartCut^{™} permet le prélèvement d'une couche de matériau piézoélectrique, d'une épaisseur contrôlée, à partir d'un substrat massif de matériau piézoélectrique dit substrat donneur. Par ailleurs, après son recyclage, le substrat donneur peut à nouveau être utilisé pour la formation d'autres substrats POI. Ce dernier aspect permet de rendre le procédé SmartCut^{™} compétitif.

Les substrats POI, ainsi susceptibles d'être formés selon le procédé SmartCut^{™}, sont généralement mis en œuvre pour la conception de filtres à ondes élastiques de surface fonctionnant à des fréquences de résonance/anti-résonance supérieures à 1 GHz.

Il existe aujourd'hui un intérêt pour la formation des filtres à ondes élastiques de surface formés sur des substrats POI et fonctionnant à des fréquences de résonance/ anti-résonance inférieures à 1 GHz. Toutefois, afin de contenir le coefficient de température de la fréquence d'un mode élastique de surface se propageant sur un substrat POI à des valeurs raisonnables (par exemple inférieures à 10 ppm.K⁻¹), il peut être nécessaire d'adapter les épaisseurs de la couche de matériau piézoélectrique et/ou de la couche de matériau diélectrique. Plus particulièrement, il peut être requis de réduire l'épaisseur de la couche de matériau diélectrique et/ou d'augmenter l'épaisseur de la couche de matériau piézoélectrique.

A cet égard, le procédé SmartCut^{™} présente la versatilité nécessaire pour adapter les épaisseurs de ces couches.

Néanmoins, une couche de matériau diélectrique fine, et notamment d'une épaisseur inférieure à 300 nm voire inférieure à 200 nm, n'est plus une barrière efficace contre la diffusion de certaines espèces susceptibles de former la couche de matériau piézoélectrique. Par exemple, une couche de matériau diélectrique d'une épaisseur inférieure à 300 nm laissera diffuser le lithium d'une couche de matériau piézoélectrique comprenant du LaTiO3. Notamment, le lithium ayant ainsi diffusé dans la couche de matériau diélectrique (par exemple du SiO₂) est source de pertes radiofréquences.

Également, il n'est pas souhaitable de considérer une couche de matériau piézoélectrique d'une épaisseur trop importante, et notamment supérieure à 500 nm. En effet, ces épaisseurs nécessitent, lors de la mise en œuvre du procédé SmartCut^{™} pour la formation du substrat POI, de considérer des énergies d'implantation dans le substrat massif de matériau piézoélectrique (le substrat donneur) relativement importantes, qui, par voie de conséquence génèrent des endommagements souvent rédhibitoires pour la formation de filtres à ondes élastiques de surface.

Un but de la présente invention est donc de proposer un procédé de fabrication d'un dispositif à ondes élastiques de surface, fonctionnant à des fréquences inférieures à 1 GHz, mettant en œuvre un procédé SmartCut^{™} et pour lequel la diffusion d'espèces au cours de l'exécution dudit procédé reste limitée.

### BREVE DESCRIPTION DE L'INVENTION

Le but de la présente invention est atteint par un procédé de fabrication d'un dispositif à ondes élastiques configuré pour fonctionner à une fréquence inférieure à 1 GHz, et formé sur un substrat POI, la formation du substrat POI comprenant les étapes suivantes :

a) une étape d'implantation d'espèces dans un substrat donneur, comprenant du LaTiO₃, l'implantation d'espèce étant destinée à former une couche, dite zone de fragilisation dans le volume du substrat donneur, et délimitant avec une face, dite face principale, dudit substrat donneur, une couche utile ;

b) une étape de report de la couche utile sur une face avant d'un substrat support, l'étape de report comprenant dans l'ordre un assemblage de la couche utile avec une face, dite face avant, du substrat support, et un traitement thermique destiné à initier une onde de fracture le long de fragilisation afin de transférer la couche utile sur la face avant ;

le procédé comprenant en outre la formation d'un empilement intermédiaire, intercalé entre la face avant et la couche utile, et qui comprend à partir de la face avant, une première couche, une deuxième couche et une troisième couche, la première couche et comprenant du dioxyde de silicium, la deuxième couche comprenant du nitrure de silicium, de l'alumine ou du nitrure d'aluminium, et la troisième couche comprenant du dioxyde de silicium ou du silicium amorphe.

Selon un mode de mise en œuvre, la formation du substrat POI comprend également une couche, dite couche de piégeage, intercalée entre l'empilement intermédiaire et la face avant, la couche de piégeage étant adaptée pour limiter le libre parcours moyen de porteurs électriques à l'interface formée entre l'empilement intermédiaire et ladite couche de piégeage au regard du libre parcours moyen de porteurs électriques à une interface formée entre l'empilement intermédiaire et le substrat support.

Selon un mode de mise en œuvre, la couche de piégeage comprend une densité de défauts supérieure à une densité de défauts prédéterminée, la densité de défauts prédéterminée étant une densité de défauts pour laquelle la résistivité de la couche de piégeage est supérieure ou égale à 10 Kilo-ohm pour des températures comprises entre -20°C et 120°C.

Selon un mode de mise en œuvre, la couche de piégeage comprend au moins l'un des matériaux compris parmi : le silicium amorphe, le silicium polycristallin.

Selon un mode de mise en œuvre, la formation de l'empilement comprend la formation de la troisième couche sur la face principale avant l'exécution de l'étape a) d'implantation.

Selon un mode de mise en œuvre, la formation de l'empilement comprend la formation de la première couche et de la deuxième couche sur la face avant de sorte que l'assemblage, lors de l'exécution de l'étape b), comprenne la mise en contact de la deuxième couche et de la troisième couche.

Selon un mode de mise en œuvre, la troisième couche est d'une épaisseur comprise entre 10 nm et 100 nm.

Selon un mode de mise en œuvre, ledit procédé comprend un étape préliminaire, exécutée avant l'étape a), et au cours de laquelle le substrat donneur est soumis à un traitement d'oxygène en phase vapeur de manière à limiter, voire réduire, les effets de pyroélectricité susceptible d'apparaître dans le substrat donneur, et par voie de conséquence dans la couche utile, lorsqu'il est soumis à une hausse de température.

Selon un mode de mise en œuvre, le substrat donneur comprend du tantalate de lithium dopée au fer, le dopage au fer étant compris entre 0,001 % et 0,05 %, avantageusement entre 0,002 % et 0,01%, en pourcentage massique.

Selon un mode de mise en œuvre, la première couche est d'une épaisseur comprise entre 100 nm et 1000 nm, avantageusement entre 300 nm et 800 nm, et la deuxième couche est d'une épaisseur comprise entre 20 nm et 300 nm.

Selon un mode de mise en œuvre, ledit procédé comprend la formation d'au moins un transducteur électroacoustique formé sur et/ou dans la couche utile.

Selon un mode de mise en œuvre, le substrat support comprend au moins l'un des éléments choisis parmi : un substrat de silicium présentant l'orientation 110, un substrat de quartz présentant une orientation (YX*t*)/θ/90° avec θ compris entre -20° et 60°, avantageusement compris entre -10° et 30°, par exemple égal à 5°.

Selon un mode de mise en œuvre, le matériau LiTaO3 présente une orientation (YX)/θ avec θ compris entre 10° et 52°, avantageusement compris entre 15° et 30°.

### Brève description des dessins

D'autres caractéristiques et avantages de l'invention ressortiront de la description détaillée qui va suivre en référence aux figures annexées sur lesquelles :

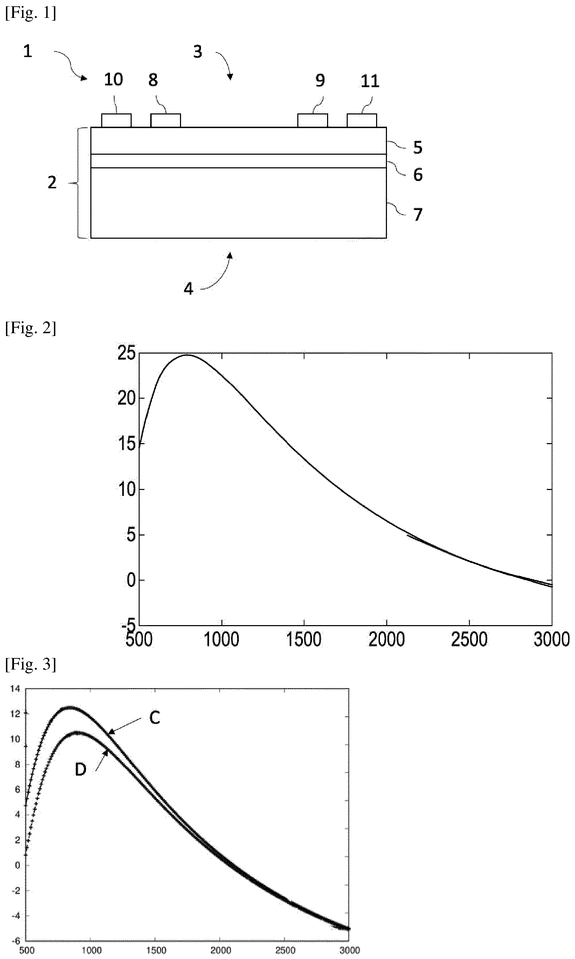

[Fig.1] La [Fig.1] est une représentation schématique d'un résonateur à ondes élastiques de surface selon un plan de coupe perpendiculaire à une face principale du substrat support du substrat POI conforme aux principes de la présente invention ;
[Fig.2] La [Fig.2] est une représentation graphique de l'évolution du coefficient TCF₁ (axe vertical, en ppm/K), du mode élastique fondamental de cisaillement de surface se propageant sous un réseau d'électrodes périodique d'un substrat POI, en fonction de la fréquence (axe horizontal, en MHz), le substrat POI dit standard qui comprend dans l'ordre, à partir de la face avant, une couche de tantalate de lithium de coupe (YXl)/42° définie selon le standard IEEE Std-176 sur la piézoélectricité de 600 nm d'épaisseur, une couche de dioxyde de silicium de 500 nm d'épaisseur, une couche de polysilicium de 1 µm, et un substrat de silicium de type 100;
[Fig.3] La [Fig.3] est une représentation graphique de l'évolution du coefficient TCF₁ (axe vertical, en ppm/K), d'un mode élastique de surface se propageant sous un réseau d'électrodes périodique d'un substrat POI, en fonction de la fréquence (axe horizontal, en MHz), notamment la courbe C et la courbe D représentent le coefficient TCF₁ associé à un substrat POI qui comprend un substrat support fait de silicium, respectivement, du type 110 ou du type (XYt)/45° ou (YXt)/45° selon la norme IEEE Std-176 ;

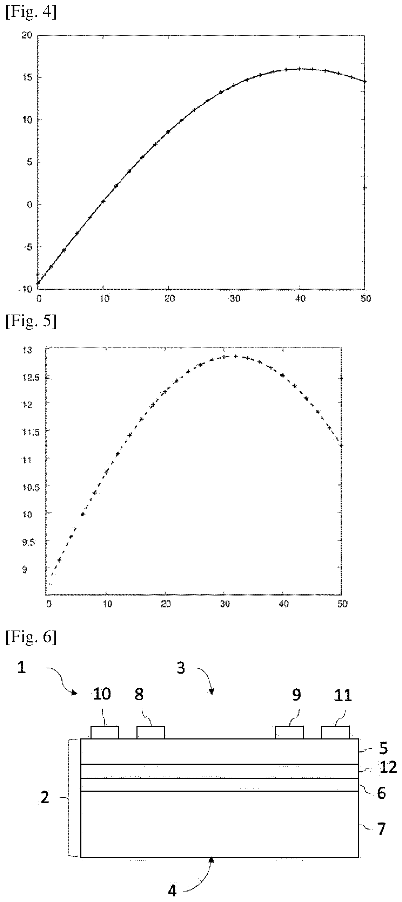

[Fig.4] La [Fig.4] représente la variation du TCF₁ (axe vertical en ppm/K) du mode élastique fondamental de cisaillement de surface se propageant sur un substrat POI et en fonction de l'angle θ de coupe (axe horizontal, en ° d'angle) de la couche de LiTaO₃, le substrat POI considéré comprenant un substrat support fait de silicium, et une couche de SiO₂ de 350 nm d'épaisseur et intercalée entre le substrat support et la couche de LiTaO₃ ;
[Fig.5] La [Fig.5] représente la variation du couplage électromécanique (axe vertical, en %) du mode élastique fondamental de cisaillement de surface se propageant sur un substrat POI décrit en relation avec la [Fig.4] et en fonction de l'angle θ de coupe (axe horizontal, en °) de la couche de LiTaO₃ ;
[Fig.6] La [Fig.6] est une représentation schématique d'un résonateur à ondes élastiques de surface selon un plan de coupe perpendiculaire à une face principale du substrat support du substrat POI conforme aux principes de la présente invention ;

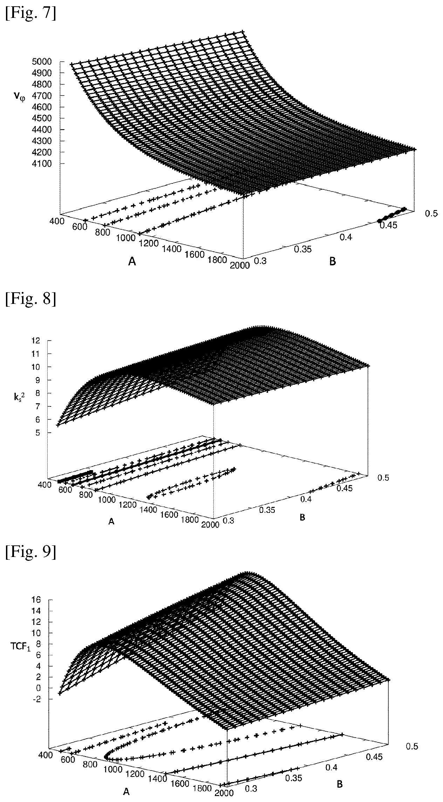

[Fig.7] la [Fig.7] représente, de manière graphique (selon une représentation 3D), la vitesse de phase des ondes susceptibles de se propager dans la couche 5 de LiTaO₃ d'un dispositif à ondes élastiques de surface formé à partir du substrat POI décrit ci-avant, la vitesse de phase, notée vϕ (axe vertical, en m/s), est représentée en fonction de la fréquence de fonctionnement du dispositif (axe A en MHz) et de l'épaisseur de la couche 6 de SiO₂ (axe B en nm) ;
[Fig.8] La [Fig.8] représente, de manière graphique (selon une représentation 3D), le facteur de couplage électromécanique du mode élastique fondamental de cisaillement de surface se propageant sur un substrat POI décrit ci-avant, le facteur de couplage électromécanique, notée kₛ² (axe vertical, en %), est représenté en fonction de la fréquence de fonctionnement d'un transducteur périodique infini formé sur ledit substrat POI (axe A en MHz) et de l'épaisseur de la couche 6 de SiO₂ (axe B en nm) ;
[Fig.9] La [Fig.9] représente, de manière graphique (selon une représentation 3D), le coefficient TCF₁ du mode élastique fondamental de cisaillement de surface se propageant dans un substrat POI décrit ci-avant, le coefficient TCF₁, notée TCF₁ (axe vertical, en ppm/K), est représenté en fonction de la fréquence de fonctionnement du transducteur (axe A en MHz) et de l'épaisseur de la couche 6 de SiO₂ (axe B en nm) ;

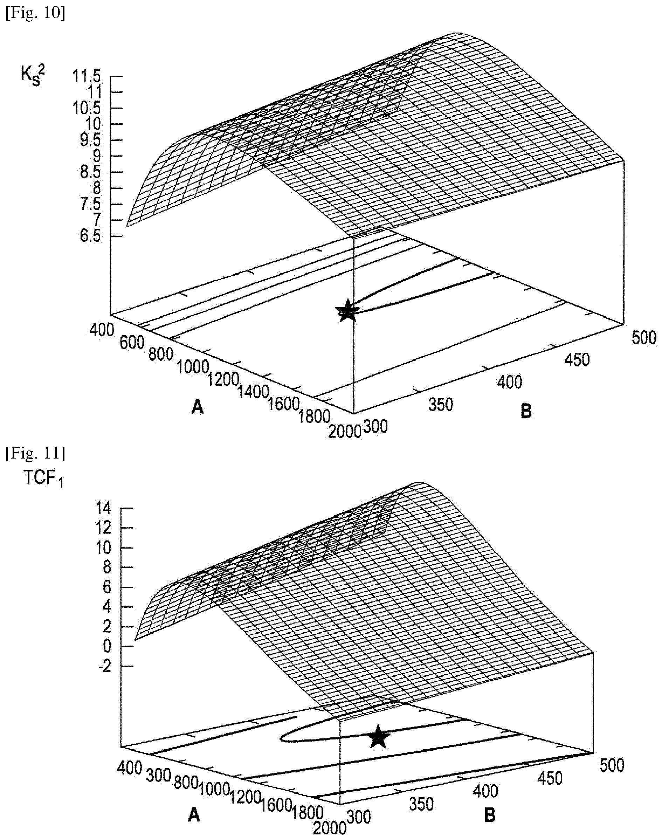

[Fig.10] La [Fig.10] représente, de manière graphique (selon une représentation 3D), le facteur de couplage électromécanique du mode élastique fondamental de cisaillement de surface se propageant dans le substrat POI décrit ci-avant et dont l'épaisseur de la couche 5 de LiTaO₃ est égale à 700 nm, le facteur de couplage électromécanique, notée kₛ² (axe vertical, en %), est représenté en fonction de la fréquence de fonctionnement du transducteur formé sur ledit substrat POI (axe A en MHz) et de l'épaisseur de la couche 6 de SiO₂ (axe B en nm).
[Fig.11] La [Fig.11] représente, de manière graphique (selon une représentation 3D), le coefficient TCF₁ du mode élastique fondamental de cisaillement de surface se propageant sur un substrat POI décrit ci-avant et dont l'épaisseur de la couche de LiTaO₃ est égale à 700 nm, le coefficient TCF₁, noté TCF₁ (axe vertical, en ppm/K), est représenté en fonction de la fréquence de fonctionnement du transducteur (axe A en MHz) et de l'épaisseur de la couche de SiO₂ (axe B en nm).

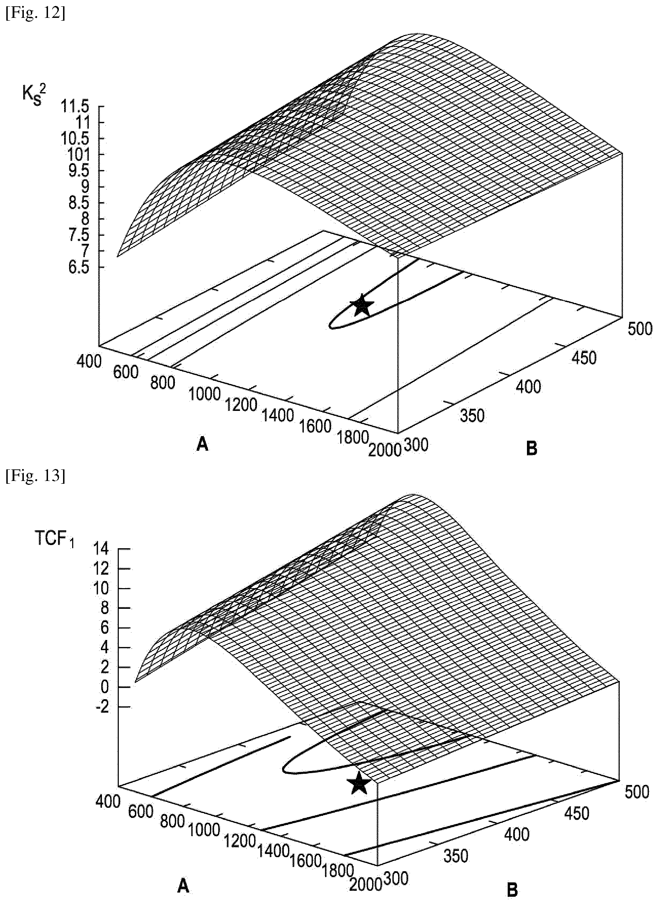

[Fig.12] La [Fig.12] représente, de manière graphique (selon une représentation 3D), le facteur de couplage électromécanique du mode élastique fondamental de cisaillement de surface se propageant sur le substrat POI décrit ci-avant et dont l'épaisseur de la couche de LiTaO₃ est égale à 800 nm, le facteur de couplage électromécanique, noté kₛ² (axe vertical, en %), est représenté en fonction de la fréquence de fonctionnement du transducteur formé sur le substrat POI(axe A en MHz) et de l'épaisseur de la couche de SiO₂ (axe B en nm) ;
[Fig.13] La [Fig.13] représente, de manière graphique (selon une représentation 3D), le coefficient TCF₁ du mode élastique fondamental de cisaillement de surface se propageant sur un substrat POI décrit ci-avant et dont l'épaisseur de la couche de LiTaO₃ est égale à 700 nm, le coefficient TCF₁, notée TCF₁ (axe vertical, en ppm/K), est représenté en fonction de la fréquence de fonctionnement du transducteur (axe A en MHz) et de l'épaisseur de la couche 6 de SiO₂ (axe B en nm) ;

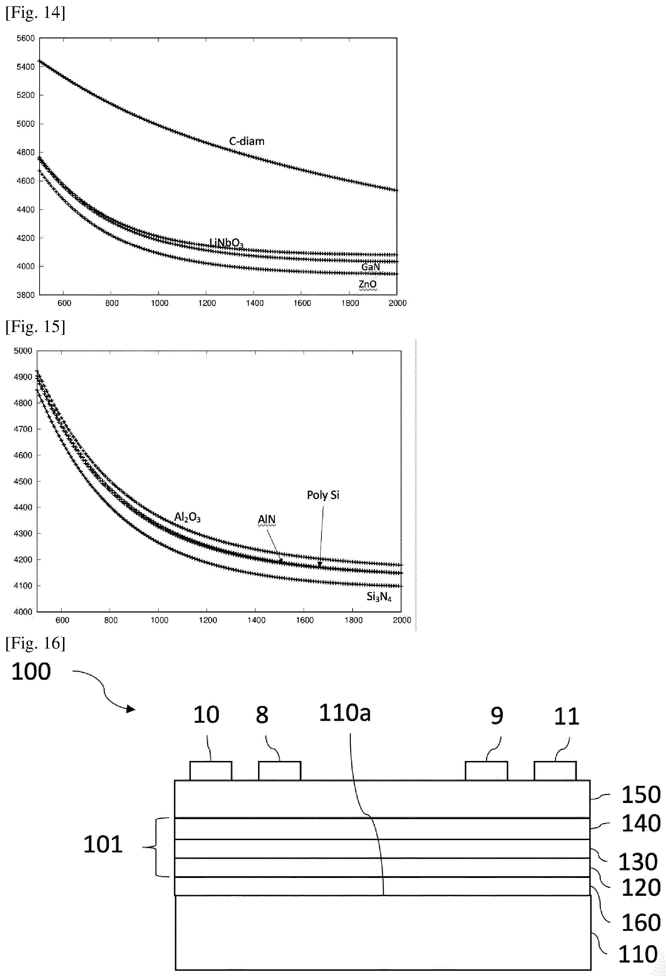

[Fig.14] La [Fig.14] est représentation graphique de l'évolution de la vitesse de phase du mode fondamental de cisaillement (axe vertical, en m/s) en fonction de la fréquence (axe horizontal en MHz) et se propageant dans un substrat POI qui comprend une couche de LiTaO₃ (YXl)42° de 600 nm, une couche additionnelle de 100 nm, une couche diélectrique de 400 nm, et un substrat support de Silicium, la couche additionnelle pouvant comprendre Carbone diamant, GaN, ZnO, LiNbO₃ ;
[Fig.15] La [Fig.15] est représentation graphique de l'évolution de la vitesse de phase du mode fondamental de cisaillement (axe vertical, en m/s) en fonction de la fréquence (axe horizontal en MHz),et se propageant dans un substrat POI qui comprend une couche de LiTaO₃ (YXl)42° de 600 nm, une couche additionnelle de 100 nm, une couche diélectrique de 400 nm, et un substrat support de Silicium, la couche additionnelle pouvant comprendre : SiN, poly Si, AlN, Al₂O₃ ;
[Fig.16] La [Fig.16] est représentation schématique d'un dispositif à ondes élastiques de surface selon un plan de coupe perpendiculaire à une face avant du substrat support conforme aux principes de la présente invention ;

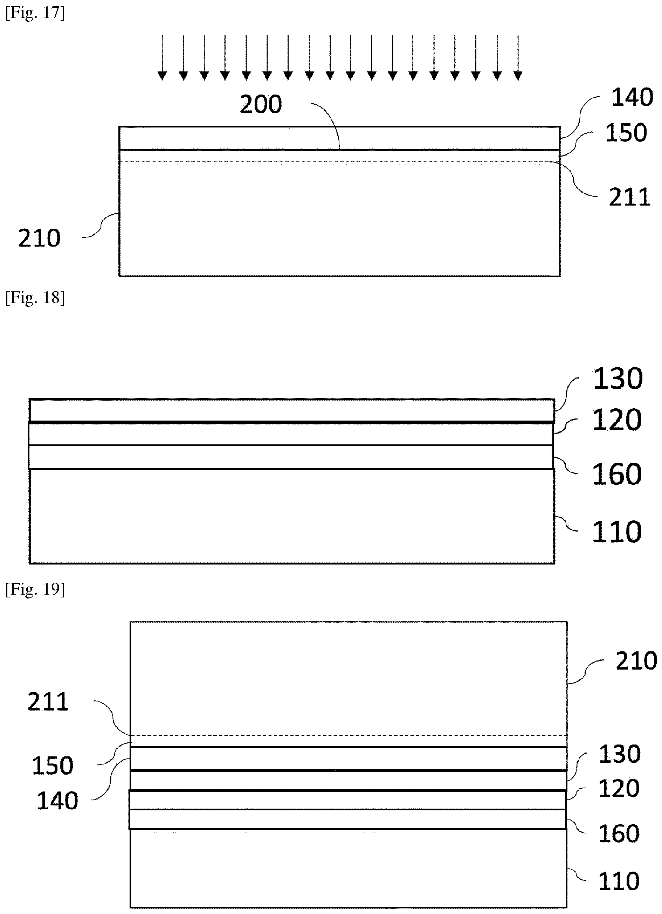

[Fig.17] La [Fig.17] est représentation schématique de l'étape a) du procédé selon la présente invention ;
[Fig.18] La [Fig.18] est représentation schématique de la formation de la première couche et de la deuxième couche sur le substrat support ;
[Fig.19] La [Fig.19] est représentation schématique de l'assemblage de la deuxième couche avec la troisième couche ;

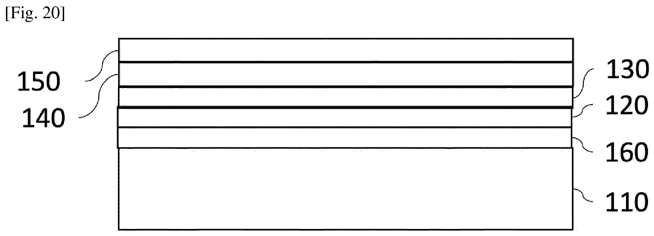

[Fig.20] La [Fig.20] est représentation schématique de la fracture le long de la zone de fragilisation.

### DESCRIPTION DETAILLEE DE L'INVENTION

Par souci de simplification de la description à venir, les mêmes références sont utilisées pour des éléments identiques ou assurant la même fonction dans les différents modes de mise en œuvre exposés de l'invention et dans l'état de la technique.

La présente invention concerne un dispositif à ondes élastiques de surface formé à partir d'un substrat POI. A cet égard, le document FR3127660 décrit un dispositif à onde élastique de surface ainsi que son principe fonctionnement.

Selon la présente invention, le dispositif à ondes élastiques de surface peut être au choix : un filtre, un résonateur, un capteur. Il est toutefois entendu que la présente invention n'est pas limitée à ces aspects, et l'homme du métier pourra en adapter les principes à tout type de dispositif à ondes élastiques de surface formé à partir d'un substrat POI.

Notamment, la présente invention concerne un dispositif à ondes élastiques de surface réalisé sur un substrat POI. Notamment, le substrat POI comprend, d'une face avant vers une face arrière, une couche de matériau piézoélectrique, une couche de matériau diélectrique et un substrat support.

A cet égard, le substrat support comprend au moins l'un des éléments choisis parmi : un substrat de silicium présentant une orientation du type (110), un substrat de quartz présentant une orientation (YXt)/θ/90° avec θ compris entre -20° et 60°, avantageusement compris entre -10° et 30°, par exemple égal à 5°.

Par ailleurs, le dispositif selon la présente invention comprend, formé sur et/ou dans la couche de matériau piézoélectrique, au moins un transducteur électroacoustique. Par exemple, et sans toutefois limiter la portée de la présente invention, le dispositif à ondes élastiques de surface comprend au moins un transducteur électroacoustique d'entrée et au moins un transducteur électroacoustique de sortie formés sur ou dans la couche de matériau piézoélectrique. L'au moins un transducteur électroacoustique selon la présente invention peut être équipé de miroirs de Bragg à électrodes. Lesdites électrodes peuvent être arrangées périodiquement, et notamment présenter une période de répétition proche de celle d'électrodes de l'au moins un transducteur, localisées de part et d'autre du transducteur. La structure peut inclure au moins un intervalle de surface libre en son sein. Le résonateur ainsi formé est utilisé comme élément d'impédance d'un f iltre combinant une ou plusieurs cellules identiques incorporant au moins un résonateur tel que décrit plus haut.

Il est entendu que l'orientation d'un substrat ou d'une couche doit être associée à son orientation cristalline, définie selon la norme IEEE 1949 Std-176.

Il est par ailleurs entendu qu'une déviation angulaire par rapport à une orientation cristalline peut être admise. Notamment, quelle que soit l'orientation cristalline considérée, il sera généralement admis que cette dernière est spécifiée à 10° près, avantageusement à 5° près, autour de ladite orientation.

La [Fig.1] est une illustration schématique d'un dispositif à ondes élastiques de surface 1 (notamment sur cette [Fig.1], le dispositif est un résonateur).

Notamment, le dispositif à ondes élastiques de surface 1 comprend un substrat POI 2.

Le substrat POI 2 comprend, à cet égard, d'une face avant 3 vers une face arrière 4, une couche de matériau piézoélectrique 5, une première couche 6 de matériau diélectrique et un substrat support 7.

A titre d'exemple, le dispositif à ondes élastiques de surface 1 est un filtre passe bande qui présente une fréquence centrale f₀ et une largeur de bande passante Δf qui peut s'exprimer comme une fraction de cette fréquence centrale, typiquement comprise entre 0,1% et 10% avec un substrat POI pourvu d'une couche piézoélectrique 5 faite de tantalate de lithium LiTaO₃. La considération d'une couche piézoélectrique 5 à base de LiNbO₃ permet de repousser la limite haute de cette fraction à 15 % et plus en choisissant l'orientation cristalline de ladite couche de façon à maximiser le couplage électromécanique du mode ainsi exploité.

Selon un mode de mise en œuvre, le dispositif à ondes élastiques de surface 1 comprend au moins un transducteur électroacoustique, par exemple, et tel qu'illustré à la [Fig.1], au moins un transducteur électroacoustique d'entrée 8 et au moins un transducteur électroacoustique de sortie 9.

Selon un autre mode de mise en œuvre, le filtre à ondes élastiques de surface est composé d'au moins une cellule pourvue d'au moins un résonateur à ondes élastiques de surface formant un quadripôle avec un port d'entrée et un port de sortie. Il s'agit alors de filtre à couplage acoustique connus par l'homme de l'art sous les appellations anglo-saxonnes de LCRF (Longitudinally Coupled Resonator Filter), filtres DMS (Double Mode SAW) ou filtres SCAW (Surface cavity Acoustic Wave). Lorsque plusieurs cellules pourvues d'un seul transducteur ou de plusieurs transducteurs connectés entre eux pour former un dipôle sont agencées en cascade par connexion électrique uniquement, le filtre résultant est généralement désigné comme un filtre à éléments d'impédance. En fonctionnement, le signal électromagnétique à filtrer est appliqué sur le port d'entrée du filtre et le signal électromagnétique filtré est prélevé sur le port de sortie du filtre. On note toutefois que la désignation « d'entrée » et « de sortie » est parfaitement arbitraire et que le dispositif, et notamment le filtre, à ondes élastiques de surface 1 peut être exploité en appliquant/prélevant indifféremment un signal électromagnétique sur l'un ou l'autre des deux ports.

D'une manière très générale, le transducteur électroacoustique d'entrée 8 et le transducteur électroacoustique de sortie 9, de même que les résonateurs utilisés comme éléments d'impédance dans les filtres à cellules agencées en cascades, sont conformes à ceux connus de l'état de la technique, dont on rappelle quelques caractéristiques ci-après.

Chaque transducteur 8 et 9 comprend deux électrodes en peigne interdigitées. De tels transducteurs 8 et 9 sont chacun formés d'un réseau de doigts métalliques qui sont alternativement reliés a deux bus entre lesquels une différence de potentiel électrique est appliquée/prélevée. Avec ce dispositif, on peut ainsi générer/détecter directement une onde élastique de surface dans la couche de matériau piézoélectrique 5. Le transducteur électroacoustique d'entrée 8 et le transducteur électroacoustique de sortie 9 sont généralement configurés pour être identiques. Toutefois, l'invention n'est pas limitée à cet aspect, l'homme du métier pourra considérer deux transducteurs différents.

Les filtres ainsi susceptibles d'être constitués sont généralement désignés comme filtres transverses. En effet, leur fonction de transfert peut avantageusement être modulée par l'interpénétration des électrodes en forme de peignes le long de la direction de propagation de l'onde. Pour ce type de composant, les transducteurs sont susceptibles de fonctionner hors de la condition de Bragg. Ces filtres sont réputés à réponse impulsionnelle finie. L'homme de l'art peut également mettre en œuvre des transducteurs fonctionnant à la condition de Bragg auxquels sont avantageusement adjoints des miroirs à chaque extrémité du filtre pour renvoyer l'énergie en phase dans la structure considérée, et donnant lieu ainsi à des filtres à réponse impulsionnelle infinie. Les filtres à éléments d'impédance mentionnés précédemment correspondent également à des filtres à réponse impulsionnelle infinie dans la mesure où ils sont constitués d'éléments résonnants.

Le métal des électrodes est typiquement à base d'aluminium, par exemple de l'aluminium pur ou un alliage d'aluminium tel que l'aluminium dopé avec Cu, Si ou Ti. Il est néanmoins possible d'utiliser un autre matériau, par exemple pour établir un coefficient de réflexion plus élevé pour une épaisseur relative d'électrode plus faible que celle nécessaire avec de l'aluminium pour atteindre des caractéristiques similaires. À cet égard, les matériaux d'électrode préférés sont le cuivre (Cu), le molybdène (Mo), le nickel (Ni), le platine (Pt) ou l'or (Au) avec une couche d'adhérence telle que le titane (Ti) ou le tantale (Ta) ou le chrome (Cr), le zirconium (Zr), le palladium (Pd), l'iridium (Ir), le tungstène (W), etc. Les électrodes peuvent également être composées de deux matériaux parmi ceux désignés ci-dessus dans le but d'optimiser le fonctionnement du transducteur via ses fonctions de réflexion acoustique, de couplage électromécanique et de pertes, en particulier ohmiques.

La période p des électrodes est généralement choisie telle que p = λ/2, λ étant la longueur d'onde de l'onde élastique qui se propage dans la couche de matériau piézoélectrique 5 à la fréquence de synchronisme fₛ du transducteur donnée par fₛ=V_{φ}/λ, V_{φ} représentant la vitesse de phase du mode exploité. Le transducteur fonctionne alors à la condition de Bragg déjà mentionnée plus haut. D'autres configurations sont possibles, et plus généralement la période p peut s'écrire comme p = λ/(nb_elec), avec nb_elec le nombre de doigts (électrodes) par longueur d'onde. Ces paramètres sont reliés par la relation λ= V/fₛ, dans laquelle V représente la vitesse de phase de l'onde élastique sous le transducteur. La vitesse de l'onde élastique en surface libre ou sous un transducteur électroacoustique dépend notamment de la nature du matériau dans lequel l'onde se propage. Cette dernière est généralement connue ou accessible à la personne du métier en utilisant spécifiquement les constantes élastiques, piézoélectriques et diélectriques ainsi que la masse volumique tabulées dans la littérature dans des modèles idoines.

Dans le cas du filtre passe-bande, notamment de fréquence et de bande passante données, il peut être considéré de mettre en œuvre des transducteurs dont les fréquences de synchronisme sont choisies pour répondre aux exigences susmentionnées. Les méthodes pour mettre en œuvre ce ou ces choix sont connues de l'homme du métier et ne sont donc pas décrites.

La largeur de métallisation des électrodes, notée a, est généralement choisie pour que le rapport a/p soit de l'ordre de 0,5. Cet aspect n'est pas de nature à limiter la portée de la présente invention, et l'homme du métier pourra considérer d'autres rapports pouvant se révéler plus avantageux pour un couple mode/matériau donné. Le nombre de paires de doigts de chaque transducteur est usuellement choisi de l'ordre de 20 ou 100 sans caractère restrictif. D'une manière générale, augmenter le nombre de paires de doigts permet d'augmenter le rejet des fréquences hors de la bande passante et réduit l'étendue spectrale de la réponse en admittance ou en impédance du transducteur autour de sa fréquence de synchronisme.

Le dispositif à ondes élastiques de surface 1 peut également comprendre deux miroirs externes 10 et 11 disposés de part et d'autre du couple des transducteurs électroacoustiques d'entrée 8 et de sortie 9. Comme cela est bien connu, ces miroirs 10 et 11 permettent de confiner un maximum de l'énergie élastique entre les deux transducteurs électroacoustiques d'entrée 8 et de sortie 9. À ce titre, ils sont conçus pour présenter un coefficient de réflexion très important, aussi proche que possible de 1 (réflexion totale de l'énergie incidente), en choisissant l'épaisseur des électrodes des miroirs et le nombre de ces électrodes, typiquement quelques dizaines par miroir dans le cas d'un substrat POI pour une onde de cisaillement. On note toutefois que ces deux miroirs externes ne sont nullement essentiels à l'invention, et qu'un dispositif conforme à l'invention et entièrement fonctionnel peut en être dépourvu.

La présente invention vise à proposer un dispositif, par exemple un filtre (sans toutefois limiter l'invention à ce seul aspect), à ondes élastiques de surface 1 pour lequel la sensibilité en température reste limitée pour des fréquences inférieures à 1 GHz.

A cet égard, le comportement en température d'un filtre à ondes élastiques de surface est généralement correctement représenté par la relation suivante :$Δ f / f = {TCF}_{1} \times \left(T-{T}_{0}\right) + {TCF}_{2} \times {\left(T-{T}_{0}\right)}^{2}$

Les exigences en termes de sensibilité en température imposent de maîtriser le coefficient TCF₁ en dessous d'une valeur seuil sur la gamme de fréquences de fonctionnement du dispositif à ondes élastiques de surface. Plus particulièrement, il est avantageux de maintenir le coefficient TCF₁ à une valeur inférieure à 20 ppm/K, avantageusement inférieure à 15 ppm/K, encore plus avantageusement inférieure à 10 ppm/ K.

Les inventeurs ont pu constater que les substrats POI connus de l'état de la technique présentent une sensibilité en température relativement importante dès lors qu'ils sont mis en œuvre pour la fabrication de dispositifs à ondes élastiques de surface fonctionnant à des fréquences inférieures à 1 GHz, et plus particulièrement comprises entre 400 MHz et 1 GHz.

Il est entendu que l'ensemble des représentations graphiques décrites dans la suite de l'énoncé de la présente invention sont le résultat de simulations numériques sur la base de modèles (mettant en œuvre une analyse à base de fonctions de Green des substrats et de méthodes numériques telles qu'éléments finis et éléments de frontière) tenant compte des caractéristiques des transducteurs étudiés. Les détails relatifs à ces simulations ne sont pas présentés dans l'énoncé qui suit. Toutefois, l'homme du métier trouvera dans le document [3], cité à la fin de la description, les éléments théoriques permettant de les reproduire.

A titre d'exemple, la [Fig.2] (courbe A) illustre la variation du coefficient TCF₁ du mode élastique fondamental de cisaillement de surface se propageant sur un substrat POI connu de l'état de la technique. Notamment, ce substrat comprend, d'une face avant vers une face arrière, les couches suivantes :
- une couche de LiTaO₃ de coupe (XYl)/42° d'une épaisseur égale à 600 m
- une couche de SiO₂ d'une épaisseur égale à 500 nm
- un substrat de silicium du type 100 et d'une épaisseur égale à 650 µm (le substrat de silicium est supposé semi-infini au sein du calcul de la variation du coefficient TCF₁).

Sur cette [Fig.2], le coefficient TCF₁ du mode élastique fondamental de cisiallement de surface se propageant sur le substrat POI connu de l'état de la technique reste inférieur à 15 ppm/K pour des fréquences de fonctionnement supérieures à 1,3 GHz, mais peut atteindre des valeurs supérieures à 20 ppm/K, voire 25 ppm/K, dès lors que la fréquence est inférieure à 1 GHz.

Afin de pallier ce problème, les inventeurs ont pu étudier l'effet de l'orientation cristalline du substrat de silicium 7.

Notamment, les inventeurs ont pu clairement observer une diminution du coefficient TCF₁ lorsque le substrat de silicium du type 100 est remplacé par un substrat de silicium 110. La considération d'un substrat de silicium 110 induit une diminution, et plus particulièrement une diminution de 1%, du facteur de couplage électromécanique du mode considéré.

La considération d'un substrat support fait de silicium 110 permet de réduire le coefficient TCF₁ pour des fréquences inférieures à 1 GHz, et notamment comprises entre 400 MHz et 1 GHz.

Plus particulièrement, selon la présente invention, il est également possible de considérer un substrat support fait de silicium du type 110 (ou (XYw)/45° cut selon la norme IEEE Std-176) ou encore du type IEEE Std-176 (XYt)/45°.

A cet égard, la [Fig.3] illustre de manière graphique l'évolution du coefficient TCF₁ en fonction de la fréquence de modes élastiques fondamentaux de cisaillement de surface guidés chacun sur un substrat POI différent. Chaque substrat POI considéré comprend une couche de matériau piézoélectrique faite de LiTa0₃ et d'une épaisseur égale à 700 nm, et une couche de matériau diélectrique faite de SiO₂ et d'une épaisseur égale à 350 nm. Par ailleurs, la courbe C est obtenue pour un substrat POI qui comprend un substrat support en silicium du type 110 tandis que la courbe D est obtenue pour un substrat POI qui comprend un substrat support en silicium du type IEEE Std-176 (XYt)/45° ou (YXt)/45°.

Dans les deux cas, le coefficient TCF₁ reste inférieur à 13 ppm/K tandis que le couplage électromécanique du mode élastique de surface considéré est peu affecté au regard de celui observé lorsque le mode élastique fondamental de cisaillement de surface est guidé par un substrat POI connu de l'état de la technique.

Les inventeurs notent qu'il est également possible de considérer un substrat support fait de quartz présentant une orientation (YX/t)/θ/90° avec θ compris entre -20° et 60°, avantageusement compris entre -10° et 30°, par exemple égal à 5°.

De manière alternative ou complémentaire, et dans le but de réduire le coefficient TCF₁, il est possible d'adapter l'empilement formé sur le substrat support 7. Notamment, la première couche 6 de matériau diélectrique comprend du dioxyde de silicium et présente une épaisseur supérieure à 300 nm, avantageusement comprise entre 300 nm et 600 nm, encore plus avantageusement comprise entre 300 nm et 400 nm.

De manière équivalente, il est possible de considérer une couche de matériau piézoélectrique 5 faite de LaTiO₃ ou de LiNbO₃ et d'une épaisseur comprise entre 300 nm et 1000 nm, avantageusement inférieure à 800 nm, encore plus avantageusement inférieure à 700 nm.

Les inventeurs ont également étudié l'effet de l'orientation cristalline de la couche de matériau piézoélectrique sur l'amplitude du coefficient TCF₁. Afin d'illustrer l'effet de l'orientation cristalline de la couche de matériau piézoélectrique, il est proposé de considérer un mode de surface guidé par un substrat POI qui comprend, de sa face avant vers sa face arrière, une couche de LiTaO₃ qui présente une épaisseur de 700 nm et une orientation cristalline (YZ1)/θ (avec θ compris entre 0° et 30°), une couche de SiO₂ qui présente une épaisseur de 350 nm et un substrat support fait de silicium.

Plus particulièrement, la [Fig.4] et la [Fig.5] représentent la variation, respectivement, du coefficient TCF₁ et du couplage électromécanique associé au mode élastique fondamental de cisaillement de surface guidé par un substrat POI décrit ci-avant et en fonction de l'angle θ de la couche de LiTaO₃. Ainsi, pour des valeurs de θ comprises entre 10° et 35°, avantageusement comprises entre 15° et 30°, le coefficient TCF₁ reste inférieure à 15 ppm/K et le coefficient électromécanique est supérieur à 10 %.

Selon un aspect complémentaire ou alternatif à ce qui précède, le substrat POI selon la présente invention, peut comprendre en outre une deuxième couche 12 intercalée entre la couche de matériau piézoélectrique 5 et la première couche 6 de matériau diélectrique ([Fig.6]). La deuxième couche 12 est avantageusement associée à un coefficient de température de la fréquence de signe opposé à celui auquel est associée la couche de matériau diélectrique 5. Ce dernier aspect permet de compenser l'effet associé à la couche de diélectrique 6 sur le coefficient TCF₁.

Il est entendu, selon la présente invention, qu'un coefficient de température de la fréquence associé à une couche d'un matériau donné, correspond au coefficient de température de la fréquence d'un mode élastique de surface se propageant sur ladite couche. Il est également entendu que, dans le cas présent, on compare deux coefficients de température de la fréquence pour des fréquences inférieures à 1 GHz.

La couche additionnelle peut comprendre un matériau diélectrique et/ou un matériau semi-conducteur, voire piézoélectrique.

Selon la présente invention, dès lors que la couche de diélectrique 6, par exemple faite de SiO₂, est associée à un coefficient de température de la fréquence positif, celui auquel est associée la deuxième couche 12, par exemple faite de SiN, de Al₂O₃ ou de AlN, est négatif.

Par ailleurs, afin de ne pas perturber les propriétés des modes acoustiques fondamentaux de cisaillement guidés par l'empilement de matériau formant le substrat POI, la couche additionnelle peut présenter, pour des fréquences inférieures à 1 GHz, une impédance acoustique supérieure ou égale à celle de la première couche 6 de matériau diélectrique.

La considération de la deuxième couche 12 permet également de réduire le coefficient TCF₁ d'un mode élastique fondamental de cisaillement guidé sur POI. Dès lors que la couche comprend du nitrure de silicium (SiN), cette réduction peut atteindre 5 ppm/K voire plus selon l'épaisseur de ladite couche.

L'ajout d'une étape de réalisation d'une couche additionnelle de TCF de signe opposé à celui de la couche de matériau diélectrique permet de respectivement réduire/ augmenter les épaisseur de la couche piézoélectrique/couche diélectrique pour atteindre un TCF donné, et ainsi reporter la couche piézoélectrique par un procédé SmartCut^{™} sans l'endommager et sans induire une diffusion de lithium dans le substrat support. Le risque de diffusion de lithium intervient au moment des recuits pour renforcer l'interface de collage ou pour exodiffuser l'hydrogène d'implantation (susceptible d'inverser des µ-domaines).

Il est entendu sans qu'il soit nécessaire de le préciser que le nitrure de silicium considéré dans la présente invention n'est pas nécessairement stœchiométrique.

Les inventeurs ont par ailleurs remarqué que le positionnement de la deuxième couche 12 sous la première couche 6 de matériau diélectrique ne produit pas d'effet notable sur le coefficient TCF₁ d'un mode élastique de surface se propageant dans le substrat POI.

De manière avantageuse, la deuxième couche 12 présente une épaisseur comprise entre 20 nm et 300 nm.

La mise en œuvre de la deuxième couche 12 permet avantageusement de considérer une couche de diélectrique 6 d'une épaisseur plus importante.

Par ailleurs, une deuxième couche 12 faite de SiN et une première couche 6 de matériau diélectrique faite de SiO₂ peuvent être formées au cours d'une même étape de procédé, et notamment dans un bâti de dépôt en phase vapeur chimique sous conditions de pression étendue (PECVD pour Pressure Enhanced Chemical Vapor Deposition selon la dénomination anglo-saxonne).

A titre d'illustration de mise en œuvre de la deuxième couche 12, les inventeurs en ont estimé l'effet sur le coefficient TCF₁ du mode élastique fondamental de cisaillement de surface guidé sur le substrat POI. Cette simulation met en œuvre une analyse à base de fonctions de Green représentant le comportement dispersif des modes sur substrats stratifiés.

Le substrat POI considéré dans cette analyse comprend, de sa face avant vers sa face arrière :
- Une couche 5 de LiTaO₃ orienté selon la coupe (YXl)/42° de ce cristal et d'une épaisseur égale à 600 nm ;
- Une couche 12 de SiN présentant une épaisseur égale à 100 nm
- Une couche 6 de SiO₂ présentant une épaisseur susceptible de prendre l'une des valeurs comprises entre 300 nm et 600 nm
- Un substrat support 7 fait de silicium.

Le substrat POI peut également comprendre une couche de piégeage faite de silicium poly cristallin et présentant une épaisseur de l'ordre de 1 µm et plus généralement comprise entre 400 nm et 2µm.

Les inventeurs ont pu évaluer la vitesse de phase des ondes susceptibles de se propager dans la couche 5 de LiTaO₃, le facteur de couplage électromécanique ainsi que le coefficient TCF₁ du mode élastique fondamental de cisaillement de surface guidé sur le substrat POI décrit ci-avant.

Les résultats de ces évaluations sont représentés à la [Fig.7], à la [Fig.8] et à la [Fig.9].

Notamment, la [Fig.7] représente, de manière graphique (selon une représentation 3D), la vitesse de phase des ondes susceptibles de se propager dans la couche 5 de LiTaO₃ du mode élastique fondamental de cisaillement de surface guidé sur le substrat POI décrit ci-avant. La vitesse de phase de ce mode, notée v_{ϕ} (axe vertical, en m/s), est représentée en fonction de la fréquence de fonctionnement du filtre (axe A en MHz) et de l'épaisseur de la couche 6 de SiO₂ (axe B en nm).

La [Fig.8] représente, de manière graphique (selon une représentation 3D), le facteur de couplage électromécanique du mode élastique fondamental de cisaillement de surface guidé sur le substrat POI décrit ci-avant. Le facteur de couplage électromécanique, notée kₛ² (axe vertical, en %), est représenté en fonction de la fréquence de fonctionnement du mode (axe A en MHz) et de l'épaisseur de la couche 6 de SiO₂ (axe B en nm).

La [Fig.9] représente, de manière graphique (selon une représentation 3D), le coefficient TCF₁ du mode élastique fondamental de cisaillement de surface guidé sur le substrat POI décrit ci-avant. Le coefficient TCF₁ (axe vertical, en ppm/K) est représenté en fonction de la fréquence de fonctionnement du mode (axe A en MHz) et de l'épaisseur de la couche 6 de SiO₂ (axe B en nm).

Conformément à la [Fig.9], le TCF₁ du mode élastique de surface considéré est inférieur à 10 ppm/K pour des fréquences comprises entre 600 MHz et 2 GHz et pour des épaisseurs de SiO₂ inférieures ou égales à 350 nm. Cette valeur relativement faible du coefficient TCF₁, au regard des modes exploités pour la fabrication des filtres connus de l'état de la technique, est imputable à la mise en œuvre de la couche 12 de SiN. Toutefois, tel qu'illustré à la [Fig.7] et à la [Fig.8], la mise en œuvre de la deuxième couche 12 induit une augmentation de la vitesse de phase et une réduction du facteur de couplage électromécanique de l'ordre de 1% au regard d'une onde élastique de cisaillement de surface guidée connu de l'état de la technique, c'est à dire dépourvu de la couche de SiN.

L'ensemble des éléments décrits dans l'énoncé de la présente invention permet d'aboutir à un ajustement du coefficient TCF₁. En effet, conformément à l'objectif technique que la présente invention se propose de résoudre, il s'agit de limiter, ou de maîtriser, l'effet de la température sur le fonctionnement d'un dispositif à ondes élastiques de surface formé à partir d'un substrat POI.

Un ajustement est illustré à titre d'exemple en considérant un dispositif à ondes élastiques de surface formé à partir du substrat POI qui comprend de sa face avant vers sa face arrière :
- Une couche 5 de LiTaO₃ orienté selon un angle (YXl)/42° ;
- Une couche 12 de SiN présentant une épaisseur égale à 100 nm ;
- Une couche 6 de SiO₂ présentant une épaisseur susceptible de prendre l'une des valeurs comprises entre 300 nm et 600 nm
- Une couche de piégeage faite de silicium poly cristallin et présentant une épaisseur de l'ordre de 1 µm ;
- Un substrat support 7 fait de silicium.

Les résultats de ces évaluations sont représentés à la [Fig.10], à la [Fig.11], à la [Fig.12] et à la [Fig.13].

La [Fig.10] représente, de manière graphique (selon une représentation 3D), le facteur de couplage électromécanique du mode élastique fondamental de cisaillement de surface guidé sur le substrat POI décrit ci-avant et dont l'épaisseur de la couche 5 de LiTaO₃ est égale à 700 nm. Le facteur de couplage électromécanique, notée kₛ² (axe vertical, en %), est représenté en fonction de la fréquence de fonctionnement du mode (axe A en MHz) et de l'épaisseur de la couche 6 de SiO₂ (axe B en nm).

La [Fig.11] représente, de manière graphique (selon une représentation 3D), le coefficient TCF₁ du mode élastique fondamental de cisaillement de surface guidé sur le substrat POI décrit ci-avant et dont l'épaisseur de la couche 5 de LiTaO₃ est égale à 700 nm. Le coefficient TCF₁, noté TCF₁ (axe vertical, en ppm/K), est représenté en fonction de la fréquence de fonctionnement du mode (axe A en MHz) et de l'épaisseur de la couche 6 de SiO₂ (axe B en nm).

La [Fig.12] représente, de manière graphique (selon une représentation 3D), le facteur de couplage électromécanique du mode élastique fondamental de cisaillement de surface guidé sur le substrat POI décrit ci-avant et dont l'épaisseur de la couche 5 de LiTaO₃ est égale à 800 nm. Le facteur de couplage électromécanique, notée kₛ² (axe vertical, en %), est représenté en fonction de la fréquence de fonctionnement du mode (axe A en MHz) et de l'épaisseur de la couche 6 de SiO₂ (axe B en nm).

La [Fig.13] représente, de manière graphique (selon une représentation 3D), le coefficient TCF₁ du mode élastique fondamental de cisaillement de surface guidé sur le substrat POI décrit ci-avant et dont l'épaisseur de la couche 5 de LiTaO₃ est égale à 800 nm (L'étoile correspond à un point de fonctionnement pour lequel kₛ² est maximum tandis que le coefficient TCF₁ est minimum). Le coefficient TCF₁, notée TCF₁ (axe vertical, en ppm/K), est représenté en fonction de la fréquence de fonctionnement du mode (axe A en MHz) et de l'épaisseur de la couche 6 de SiO₂ (axe B en nm).

La mise en œuvre de la deuxième couche 12 de SiN, permet, pour une couche 6 de SiO₂ d'une épaisseur inférieure à 400 nm et une couche de LiTaO₃ d'une épaisseur égale à 700 nm, d'obtenir un facteur de couplage électromécanique du mode supérieur à 10 % ([Fig.10]) pour des fréquences comprises entre 800 MHz et 1600 MHz, et un coefficient TCF₁, proche de 10 ppm/K ([Fig.11]).

De manière équivalente, la même deuxième couche 12 de SiN, permet, pour une couche 6 de SiO₂ d'une épaisseur inférieure à 400 nm et une couche de LiTaO₃ d'une épaisseur égale à 800 nm, d'obtenir un facteur de couplage électromécanique du mode supérieur à 11 % ([Fig.12]) pour des fréquences comprises entre 800 MHz et 1600 MHz, et un coefficient TCF₁ᵣ proche inférieur à 10 ppm/K ([Fig.13]).

L'ensemble de la description se limite aux paramètres relatifs au mode fondamental de cisaillement selon sa fréquence de fonctionnement, et plus particulièrement à la maîtrise du paramètre TCF₁ caractérisant le mode élastique de surface considéré. Toutefois, l'homme du métier comprendra qu'un dispositif à ondes élastiques de surface fondé sur l'exploitation du mode d'intérêt présente également une fréquence de résonance et une fréquence d'anti-résonance, elle-même caractérisée par son propre coefficient TCF₁. Un coefficient TCF₁, caractérisant la résonance, très faible, voire nul, peut avoir un impact négatif sur le coefficient TCF₁ caractérisant l'anti-résonance du dispositif considéré, en particulier dans le cas des coupes à simple rotation de niobate et de tantalate de lithium connue pour présenter pour un même mode et particulièrement pour les modes de cisaillement des TCF de la résonance et de l'antirésonance différents entre eux.

La présente invention propose donc également une optimisation des paramètres caractérisant le substrat POI afin de mieux apprécier les coefficients TCF₁ relatifs, respectivement, à la résonance et à l'anti-résonance d'un dispositif formé sur ledit substrat. Plus particulièrement, la présente invention propose d'ajuster le coefficient TCF₁ relatif à la résonance (ci-après TCF₁ᵣ) et le coefficient TCF₁ relatif à l'anti-résonance (ci-après TFC_{1AR}). Notamment, la présente invention propose d'ajuster le coefficient TCF₁ᵣ à des valeurs inférieures à 15 ppm/K et le coefficient TFC_{1AR} à des valeurs comprises entre -4 ppm/K et 0 ppm/K. De manière équivalente, la présente invention propose d'ajuster le coefficient TCF_{1R} à des valeurs inférieures comprises entre 5 ppm/K et 10 ppm/K et le terme TFC_{1AR} à des valeurs comprises entre -10 ppm/ K et -5 ppm/K.

Ces objectifs peuvent notamment être atteints par la mise en œuvre de simulations de l'évolution des différents termes et coefficients décrits ci-avant afin de procéder aux définitions des couches matériaux et de leurs épaisseurs respectives.

Les inventeurs ont également étudié des matériaux autres que le SiN pour former la deuxième couche 12.

Plus particulièrement, la deuxième couche 12 peut comprendre au moins un des matériaux choisi parmi : SiC, Al₂O₃, AlN, Carbone diamant, GaN, LiNbO₃, ZnO.

La [Fig.14] est une représentation graphique de l'évolution de la vitesse de phase du mode de cisaillement fondamental (axe vertical, en m/s) en fonction de la fréquence (axe horizontal en MHz) sur un substrat POI qui comprend une couche de LiTaO₃ (YXl)42° de 600 nm, une couche additionnelle de 100 nm, une couche diélectrique de 400 nm, et un substrat support de Silicium, la couche additionnelle pouvant comprendre du Carbone diamant, du GaN, du ZnO, du LiNbO₃.

La [Fig.15] est une représentation graphique de l'évolution de la vitesse de phase du mode de cisaillement fondamental (axe vertical, en m/s) en fonction de la fréquence (axe horizontal en MHz) sur un substrat POI qui comprend une couche de LiTaO₃ (YXl)42° de 600 nm, une couche additionnelle de 100 nm, une couche diélectrique de 400 nm, et un substrat support de Silicium, la couche additionnelle pouvant comprendre du SiN, du poly-Si, de l'AlN, de l'Al₂O₃.

Ainsi, à l'exception du carbone diamant, le même comportement est observé lorsque la vitesse de phase du mode tend vers la vitesse de l'onde de cisaillement dans le silicium aux basses fréquences. La diminution de ladite vitesse mode équivaut à augmenter la longueur d'onde du mode considéré pour une fréquence donnée, et réduit ainsi l'influence de la structure composite du substrat POI.

De ces observations et d'un traitement mathématique approprié (la considération de la dérivée de la vitesse de phase par rapport à la fréquence), il ressort que le LiNbO₃ est le matériau le plus favorable pour minimiser la sensibilité modale à la fréquence dans la gamme 800-1200 MHz.

Une deuxième couche 12 faite de Carbone diamant semble avantageuse pour les fréquences inférieures à 800 MHz.

La mise en œuvre d'une couche additionnelle de LiNbO₃, et d'une épaisseur de 100 nm, disposée entre une couche diélectrique 6 faite de SiO₂ et une couche piézoélectrique 5 faite de LiTaO₃, permet de réduire le coefficient TCF₁ à une valeur inférieure à 10 ppm/K, et ce quelle que soit l'orientation cristalline de la couche piézoélectrique.

La présente invention telle que décrite précédemment couvre une pluralité d'aspects qui peuvent être considérés de manière indépendante ou en combinaison afin d'optimiser (réduire) le coefficient TCF₁ à des valeurs inférieures à 20 ppm/K, avantageusement inférieures à 15 ppm/K, encore plus avantageusement inférieures à 10 ppm/ K, dès lors que la fréquence de fonctionnement du dispositif et en particulier du filtre à ondes élastiques de surface est inférieure à 1 GHz.

De manière avantageuse, le substrat POI comprend également une couche de piégeage intercalée entre la couche de matériau diélectrique et le substrat support, la couche de piégeage étant adaptée pour limiter le libre parcours moyen de porteurs électriques à l'interface formée entre la couche de matériau diélectrique et la couche de piégeage au regard du libre parcours moyen de porteurs électriques à une interface formée entre la couche de matériau diélectrique et le substrat support.

A cet égard, la couche de piégeage peut comprendre du silicium poly cristallin et présente avantageusement une épaisseur comprise entre 400 nm et 2000 nm.

L'invention concerne également un procédé de fabrication du dispositif à ondes élastiques de surface.

Ledit procédé comprend notamment la formation du dispositif à ondes élastiques de surface à partir d'un substrat POI. Le procédé comprend avantageusement la formation du substrat POI.

Procédé de fabrication d'un dispositif à ondes élastiques configuré pour fonctionner à une fréquence inférieure à 1 GHz, et formé sur un substrat POI.

La formation du substrat POI comprend avantageusement les étapes suivantes :

a) une étape d'implantation d'espèces dans un substrat donneur, fait d'un matériau piézoélectrique, l'implantation d'espèce étant destinée à former une couche, dite zone de fragilisation dans le volume du substrat donneur, et délimitant avec une face, dite face principale, dudit substrat donneur, une couche utile ;

b) une étape de report de la couche utile sur une face avant d'un substrat support, l'étape de report comprenant dans l'ordre un assemblage de la couche utile avec une face, dite face avant, du substrat support, et un traitement thermique destiné à initier une onde de fracture le long de la zone de fragilisation afin de transférer la couche utile sur la face avant ;

Le procédé comprend par ailleurs la formation d'un empilement intermédiaire 101, intercalé entre la face avant et la couche utile, et qui comprend à partir de la face avant, une première couche, une deuxième couche et une troisième couche, la première couche et la troisième couche comprenant du dioxyde de silicium, et la deuxième couche comprenant du nitrure de silicium.

Ainsi, la [Fig.16] est une illustration d'un substrat POI 100 susceptible d'être obtenu par l'exécution du procédé de fabrication selon la présente invention. Notamment, le substrat POI comprend, dans l'ordre, un substrat support 110, une première couche 120, une deuxième couche 130, une troisième couche 140 (la première couche 120, la deuxième couche 130 et la troisième couche 140 formant un empilement intermédiaire 101) et une couche utile 150.

A cet égard, la première couche 120 peut comprendre du SiO2, la deuxième couche 130 peut comprendre du nitrure de silicium (SiN), et la troisième couche 140 peut comprendre du SiO₂.

De manière avantageuse, le substrat POI 100 peut également comprendre une couche de piégeage 160. Notamment, la couche de piégeage 160 peut comprendre du silicium amorphe et/ou du silicium polycristallin.

La couche de piégeage 160 est intercalée entre l'empilement intermédiaire 101 et une face avant 110a du substrat support 110. Notamment, la couche de piégeage 160 est adaptée pour limiter le libre parcours moyen de porteurs électriques à l'interface formée entre l'empilement intermédiaire et ladite couche de piégeage au regard du libre parcours moyen de porteurs électriques à une interface formée entre l'empilement intermédiaire et le substrat support.

De manière avantageuse, le substrat support comprend au moins l'un des éléments choisis parmi : un substrat de silicium présentant l'orientation 110, un substrat de quartz présentant une orientation (YX/t)/θ/90° avec θ compris entre -20° et 60°, avantageusement compris entre -10° et 30°, par exemple égal à 5°.

La [Fig.17] est une illustration de l'étape a). Notamment, l'étape a) comprend l'implantation d'espèces par une face, dite face principale 200 d'un substrat donneur 210 qui comprend un matériau piézoélectrique.

Notamment, l'étape a) est exécutée de manière à former une couche, dite zone de fragilisation 211 dans le volume du substrat donneur 210, et délimitant avec la face principale 200, dudit substrat donneur, la couche utile 150.

Il est entendu, sans qu'il soit nécessaire de le préciser, que la zone de fragilisation 211 forme une couche essentiellement parallèle à la face principale 200.

Il est également entendu que l'épaisseur de la couche utile 150 est fonction des conditions d'implantation des espèces et de leur nature.

Par exemple, l'homme du métier, pour l'exécution de l'étape a), pourra considérer l'implantation d'ions d'hydrogène ou d'hélium.

De manière avantageuse, l'étape a) peut être précédée d'une étape préliminaire, et au cours de laquelle le matériau piézoélectrique est soumis à un traitement d'oxygène en phase vapeur de manière à limiter, voire réduire, les effets de pyroélectricité susceptibles d'apparaître dans le substrat donneur, et par voie de conséquence dans la couche utile, lorsqu'il est soumis à une hausse de température.

Le procédé peut également comprendre la formation de la couche de matériau diélectrique sur l'un ou l'autre du substrat donneur ou du substrat support, notamment par PECVD.

Le procédé peut également comprendre la formation de la couche additionnelle, par exemple sur la couche diélectrique si cette dernière est formée en premier lieu sur le substrat support.

De manière avantageuse, le substrat donneur 210 peut comprendre du tantalate de lithium dopée au fer, le dopage au fer étant compris entre 0,001 % et 0,05 %, avantageusement entre 0,002 % et 0,01%, en pourcentage massique.

De manière avantageuse, la formation de l'empilement intermédiaire 101 peut comprendre la formation de la troisième couche 140 sur la face principale avant l'exécution de l'étape a) d'implantation. La troisième couche 140 peut être formée par PECVD.

De manière avantageuse, la troisième couche est d'une épaisseur comprise entre 10 nm et 100 nm.

Dès lors que la troisième couche comprend du SiO₂, les épaisseurs précités correspondent typiquement un des épaisseurs inférieures à λ/20 et idéalement inférieures à λ/50 où λ est la longueur d'onde acoustique égale à deux fois la période mécanique d'un transducteur inter-digité fonctionnant à la fréquence de Bragg.

De manière équivalente, la formation de l'empilement intermédiaire peut comprendre la formation de la première couche 120 sur une face avant 110 d'un substrat support 110, puis la formation de la deuxième couche 130 en recouvrement de la première couche 120 ([Fig.18]).

De manière avantageuse, la première couche est d'une épaisseur comprise entre 100 nm et 1000 nm, avantageusement entre 300 nm et 800 nm, et la deuxième couche est d'une épaisseur comprise entre 20 nm et 300 nm.

La rapport de l'épaisseur de la deuxième couche sur l'épaisseur de la première couche sera avantageusement compris entre 1:4 et 1:3.A titre d'exemple, l'épaisseur de la couche piézoélectrique faite de LaTiO₃ peut être comprise entre 500 nm et 800 nm, la deuxième couche, faite de SiN, peut présenter une épaisseur comprise entre 100 nm et 200 nm, et la première couche, faite de SiO₂, peut présenter une épaisseur comprise entre 300 et 600nm.

Les formations de la troisième couche 140 d'une part, et de la première couche 120 et de la deuxième couche 130 d'autre part sont suivies d'une étape b) de report de la couche utile 150 sur une face avant d'un substrat support, l'étape de report comprenant dans l'ordre un assemblage de la couche utile avec une face, dite face avant 110a, du substrat support 110, et un traitement thermique destiné à initier une onde de fracture le long de la zone de fragilisation afin de transférer la couche utile 150 sur la face avant 110a.

De manière avantageuse, l'assemblage peut comprendre la mise en contact de la deuxième couche 130 et de la troisième couche 140 ([Fig.19]).

Ainsi, selon la présente invention, la troisième couche est une couche d'adhésion formée au moins pour partie sur le substrat donneur et plus particulièrement sur la face principale dudit substrat donneur.

Ce dernier aspect autorise ainsi l'exécution, avant l'assemblage, d'un traitement thermique d'exodiffusion de l'hydrogène susceptible d'être présent dans la deuxième couche. En effet, la deuxième couche, qui comprend du SiN, est obtenue par dépôt en phase gazeuse d'un mélange de silane avec du NH3 et/ou du N2. Par voie de conséquence, ladite deuxième couche comprend de l'hydrogène qui convient d'éliminer afin d'éviter sa migration vers la couche piézoélectrique à l'issue de l'étape b). Ainsi, la formation de la deuxième couche sur la face avant du substrat support permet d'exécuter un traitement thermique uniquement au substrat support, à la première couche et à la deuxième couche. Ce dernier aspect permet de limiter l'histoire thermique du matériau piézoélectrique et d'en préserver les propriétés (notamment limiter les risques d'inversion de domaine). La considération de la troisième couche formée, au moins en partie sur la face principale du substrat donneur permet de considérer cette dernière comme une couche de collage. En d'autres termes, cet aspect limite l'histoire thermique du matériau piézoélectrique et limite les risques d'inversion de domaines.

L'épaisseur de la troisième couche de SiO₂ est comprise entre 10nm (couvrante sur toute la surface) et 50nm.

Alternativement, il est possible de faire un collage ADB avec une troisième couche faite de silicium amorphe d'une épaisseur de quelques nm.

L'assemblage est avantageusement un collage moléculaire.

La [Fig.20] illustre un traitement thermique destiné à initier une onde de fracture le long de la zone de fragilisation afin de transférer la couche utile 150 sur la face avant afin de former le substrat POI représenté à la [Fig.16].

Le procédé peut également comprendre la formation la couche de piégeage 160 sur le substrat support 110 préalablement à la formation de la première couche 120. En d'autres termes, le première couche 120 est formée en recouvrement de la couche de piégeage.

Bien sûr, l'invention n'est pas limitée aux modes de réalisation décrits et l'on peut y apporter des variantes de réalisation sans sortir du cadre de l'invention tel que défini par les revendications.

### RÉFÉRENCES

[1] T. Pastureaud, et al., "High-Frequency Surface Acoustic Waves Excited on Thin-Oriented LiNbO3 Single-Crystal Layers Transferred Onto Silicon", IEEE Trans. on UFFC, vol. 54, no. 4, pp.870-876, 2007;
[2] US 2014/0152146 A1 ;
[3] S. Ballandras, et al., "Simulations of surface acoustic wave devices built on stratified media using a mixed finite elementlboundary integral formulation", Journal of Applied Physics, Vol. 95, n 12, pp. 7731-7741, 2004.

## Revendications

1. Substrat POI (100) comprenant :
- un substrat support (110) comprenant une face avant (110a) ;
- une couche utile (150) comprenant du LiTaO3 sur la face avant (110a) du substrat support (110) ;
- un empilement intermédiaire (101) intercalé entre la face avant (110a) et la couche utile (5), comprenant à partir de la face avant (110a), une première couche (120), une deuxième couche (130) et une troisième couche (140),
o la première couche (120) comprenant du dioxyde de silicium, étant d'une épaisseur comprise entre 100 nm et 1000 nm, avantageusement entre 300 nm et 800 nm ;
o la deuxième couche (130) comprenant du nitrure de silicium, étant d'une épaisseur comprise entre 20 nm et 300 nm ;
o la troisième couche (140) comprenant du dioxyde de silicium ou du silicium amorphe et étant d'une épaisseur comprise entre 10 nm et 100 nm.

2. Substrat POI (100) selon la revendication précédente, comprenant également une couche de piégeage (160) intercalée entre l'empilement intermédiaire (101) et la face avant (110a), ladite couche de piégeage (160) étant adaptée pour limiter le libre parcours moyen de porteurs électriques à l'interface formée entre l'empilement intermédiaire (101) et ladite couche de piégeage (160) au regard du libre parcours moyen de porteurs électriques à une interface formée entre l'empilement intermédiaire (101) et le substrat support (110).

3. Substrat POI (100) selon la revendication précédente, dans lequel la couche de piégeage (160) comprend une densité de défauts supérieure à une densité de défauts prédéterminée, la densité de défauts prédéterminée étant une densité de défauts pour laquelle la résistivité de la couche de piégeage (160) est supérieure ou égale à 10 Kilo-ohm pour des températures comprises entre -20°C et 120°C.

4. Substrat POI (100) selon une des revendications 2 et 3, dans lequel la couche de piégeage (160) comprend au moins l'un des matériaux compris parmi : silicium amorphe, silicium polycristallin.

5. Substrat POI (100) selon l'une des revendications 1 à 4, dans lequel la couche utile (150) comprend du tantalate de lithium dopé au fer, le dopage au fer étant compris entre 0,001 % et 0,05 %, avantageusement entre 0,002 % et 0,01%, en pourcentage massique.

6. Substrat POI (100) selon l'une des revendications 1 à 5, comprenant au moins un transducteur électroacoustique (8 ;9) sur et/ou dans la couche utile (150).

7. Substrat POI (100) selon l'une des revendications 1 à 6, dans lequel le substrat support (110) comprend au moins l'un des éléments choisis parmi : un substrat de silicium présentant l'orientation 110, un substrat de quartz présentant une orientation (YX/t)/0/90° avec 0 compris entre -20° et 60°, avantageusement compris entre -10° et 30°, par exemple égal à 5°.

8. Substrat POI (100) selon l'une des revendications 1 à 7, dans lequel le matériau LiTaO3 présente une orientation (YX)/θ avec θ compris entre 10° et 52°, avantageusement compris entre 15° et 30°.

9. Substrat POI (100) selon l'une des revendications 1 à 8, dans lequel la couche utile (150) présente une épaisseur comprise entre entre 500 nm et 800 nm.

10. Substrat POI (100) selon l'une des revendications 1 à 9, dans lequel rapport de l'épaisseur de la deuxième couche sur l'épaisseur de la première couche est compris entre 1:4 et 1:3.

11. Substrat POI (100) selon l'une des revendications 1 à 10, dans lequel la deuxième couche présente une épaisseur comprise entre 100nm et 200 nm.

12. Substrat POI (100) selon l'une des revendications 1 à 11, dans lequel la première couche présente une épaisseur comprise entre 300 nm et 600 nm.
